# EUROPEAN PATENT APPLICATION

(11) **EP 4 716 452 A1**
(43) Date of publication of application: **25.03.2026**
(21) Application number: 25203521.7
(22) Date of filing: 20.09.2025
(51) Int. Cl.: H10W 74/10, H10W 40/77, H10W 74/01

(54) **A SEMICONDUCTOR PACKAGE**

(30) Priority: 20.09.2024 NL 2038677; 16.02.2025 NL 2039781
(71) Applicant: Nexperia B.V., 6534 AB Nijmegen (NL)
(72) Inventor: Dchar, Ilijas, Manchester (GB); Yandoc, Ricardo Lagmay, Manchester (GB); Brown, Adam, Manchester (GB); Becker, Michael, Manchester (GB)
(74) Representative: Pjanovic, Ilija

(57) **Abstract**

An encapsulated semiconductor package is proposed at least comprising a lead frame made from an electrically conductive metal material as well as at least two terminals; at least one semiconductor die structure having a first die side and a second die side opposite to the first die side and mounted with its second die side on the lead frame; a plurality of connections electrically and mechanically connecting the at least one semiconductor die structure with the at least two terminals of the lead frame; at least one heat sink pad mounted to the first die side of the semiconductor die structure; and a moulding resin encapsulating the lead frame, the at least one semiconductor die structure, the plurality of connections, the at least one heat sink pad and the at least two terminals leaving at least a portion of the heat sink pad and at least a portion of the at least two terminals exposed, and forming the semiconductor package having a heat sink pad package surface side and a lead frame package surface side, wherein the moulding resin at the heat sink pad package surface side and/or the lead frame package surface side is provided with at least one resin spacer element extending from the respective package surface side.

## Description

### TECHNICAL FIELD

The present disclosure relates to a semiconductor package, in particular to a top-side cooled semiconductor package.

### BACKGROUND OF THE DISCLOSURE

Top-side cooling of a semiconductor package, an alternative to bottom-side cooling, involves mounting a heatsink on the top of a device. This approach offers many benefits, including better thermal performances than the equivalent bottom-side cooling packages.

In the prior art top-side cooled semiconductor packages have been introduced, where the heat flows through the top of the semiconductor package via a layer of thermal interface material (TIM) directly to the heatsink. Usually the TIM is applied as a layer between the top-side of the semiconductor package and the heat sink. The load on top of the semiconductor package coming from the mounted heatsink may compress the TIM layer, resulting to thin the TIM layer. A decreasing thickness of the TIM layer between the top-side of the semiconductor package and the heat sink may result in a reduced isolation, which could eventually lead to a breakdown of the semiconductor package. Accordingly, designing top-side cooled semiconductor packages is hampered by the trade-off between a desired TIM thickness and a required electrical insulation.

Accordingly, it is a goal of the present disclosure to provide an improved semiconductor package that enables either a better control of the TIM thickness while ensuring a proper electrical insulation between the exposed metal pad of the power package and the heatsink, or to control or protect a correct solder thickness between the exposed drain terminal of the package and the PCB footprint or heatsink.

### SUMMARY OF THE DISCLOSURE

According to a first example of the disclosure, a semiconductor package is proposed which at least comprises a lead frame made from an electrically conductive metal material comprising at least two terminals; at least one semiconductor die structure having a first die side and a second die side opposite to the first die side and mounted with its second die side on the lead frame; a plurality of connections electrically and mechanically connecting the at least one semiconductor die structure with the at least two terminals of the lead frame; as well as at least one heat sink pad mounted to the first die side of the semiconductor die structure.

A moulding resin is used for encapsulating the lead frame, the at least one semiconductor die structure, the plurality of connections, the at least one heat sink pad and the at least two terminals in such a way, that at least a portion of the heat sink pad and at least a portion of the at least two terminals remain exposed.

The semiconductor package thus formed is provided with a package surface side oriented at the heat sink pad and a package surface side oriented at the lead frame, and the moulding resin at the drain pad package surface side and/or the lead frame package surface side is provided with at least one resin spacer element extending from the respective package surface side.

The at least one resin spacer element extending from the respective package surface side creates a spacing between either the drain pad package surface side and/or the lead frame package surface side. The height dimension of the spacing, thus the height of at least one resin spacer element ensures a constant spacing between the respective package surface side of the semiconductor package and accordingly the thickness of the TIM layer or the solder layer once the semiconductor package is provided with a heatsink on its drain pad package surface side or mounted to a printed circuit board with its lead frame package surface side. Herewith, a proper electrical insulation between the exposed metal pad of the power package and the heatsink, or a correct solder thickness with the PCB is ensured.

In a particular example, the at least one resin spacer element is provided near or at an outer circumference of the respective package surface side. Accordingly, the electrical insulation between the exposed drain pad and the heatsink, and/or the electrical connection between the lead frame and the PCB is not hampered whilst ensuring the proper spacing between the semiconductor package and either the heatsink and/or the PCB.

In a further detail similarly improving the above advantage, the at least one resin spacer element is provided near or at a corner of the respective package surface side.

The at least one resin spacer element may be configured as a protruded feature, or may be configured as at least one ridge.

In the latter example, the at least one ridge may extend along an outer circumference of the respective package surface side and in particular it may be formed as a single circumferential ridge circumventing the outer circumference of the respective package surface side. In a similar fashion, with these example, the electrical insulation between the exposed drain pad and the heatsink, and/or the electrical connection between the lead frame and the PCB is not hampered whilst ensuring the proper spacing between the semiconductor package and either the heatsink and/or the PCB.

In a further example, the at least one ridge extends across the respective package surface side, in particular the at least one ridge is formed as a grid.

It should be noted, that the at least one resin spacer element may have a height of 20-50 µm, in particular 20-30 µm, whereas the at least one resin spacer element may have a width of 20-50 µm.

### BRIEF DESCRIPTION OF THE DRAWINGS

The disclosure will now be discussed with reference to the drawings, which show in:
Figures 1A-1D details of a first example of a semiconductor package according to the disclosure;
Figure 2 a second example of a semiconductor package according to the disclosure;
Figure 3 a third example of a semiconductor package according to the disclosure;
Figures 4A-4B details of a fourth example of a semiconductor package according to the disclosure;
Figure 5A-5C details of a fifth example of a semiconductor package according to the disclosure; in a different orientation (bottom cooled);
Figures 6A-6B details of a sixth example of a semiconductor package according to the disclosure with bottom cooled orientation;
Figure 7 an implementation of the first example of a semiconductor package according to the disclosure provided with a heat sink.

### DETAILED DESCRIPTION OF THE DISCLOSURE

For a proper understanding of the disclosure, in the detailed description below corresponding elements or parts of the disclosure will be denoted with identical reference numerals in the drawings.

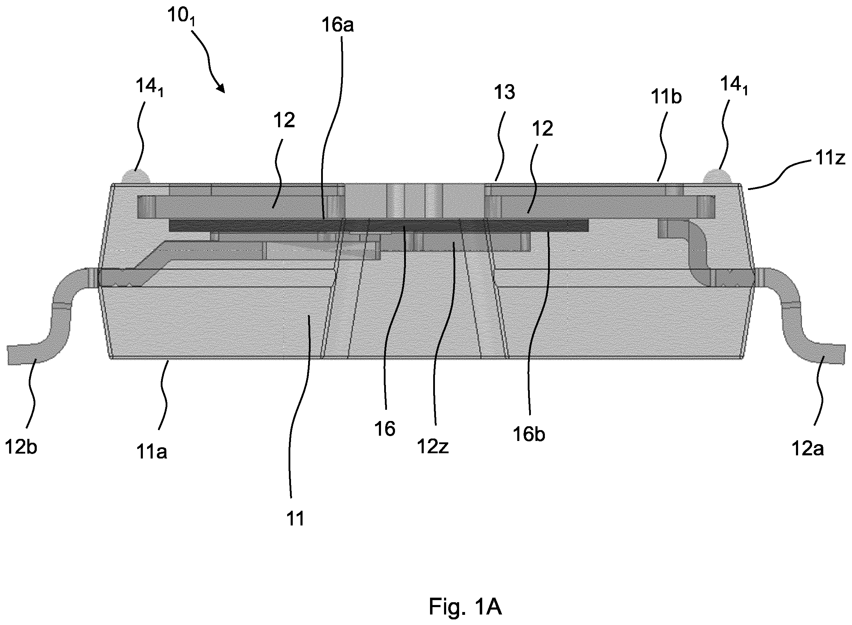

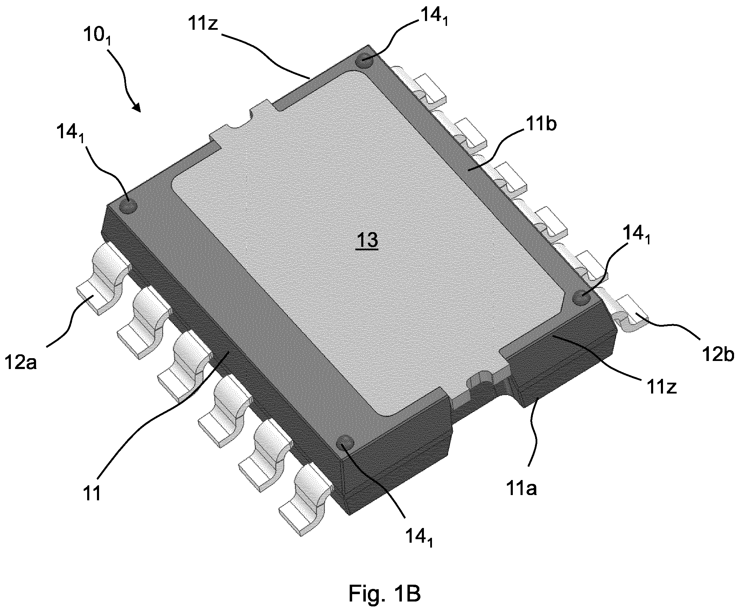

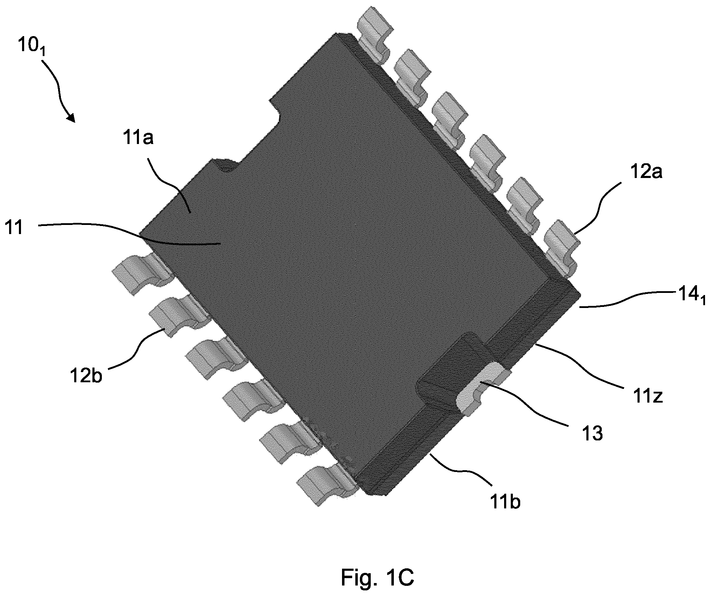

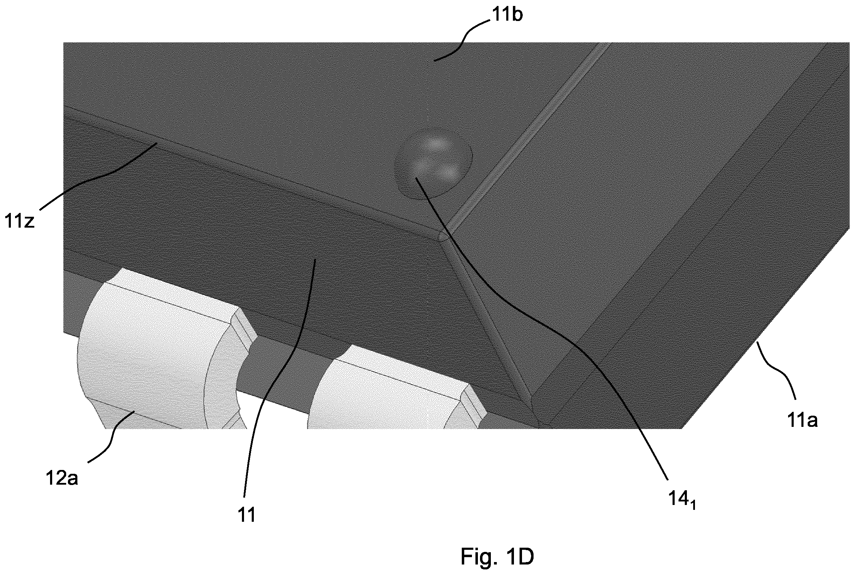

Figures 1A-1D depicts the details of a first example of a semiconductor package according to the disclosure that enables a better control of the TIM thickness between the package and a heat sink mounted on top of the semiconductor package, while ensuring a proper electrical insulation between the exposed drain pad of the package and the heatsink.

The first example of a top-side cooled semiconductor package according to the disclosure is denoted with reference numeral 10₁. As shown in the drawings, such semiconductor package at least comprises a lead frame 12 made from an electrically conductive metal material comprising at least two terminals. In the Figures the terminals are denoted with reference numerals 12a and 12b, and may be formed in an array of multiple terminals arranged side-by-side.

Usually, the at least one semiconductor die structure 16 has a first die side 16a and a second die side 16b opposite to the first die side 16a. The semiconductor die structure is mounted on the lead frame 12 and a plurality of internal connections, such as bond wires or bond clips 12z, which electrically and mechanically connect the at least one semiconductor die structure with the various terminals 12a-12b of the lead frame 12.

Moreover, in top-side cooled semiconductor packages at least one heat sink pad 13 is mounted to the first die side 16a of the semiconductor die structure 16.

The semiconductor package is formed by means of a moulding resin 11, which encapsulates the lead frame, the at least one semiconductor die structure, the bond wires and/or the bond clips, the at least one heat sink pad 13 and the various terminals 12a-12b in such a way, that at least an outer portion of the heat sink pad 13 and at least an extended portion of the terminals 12a-12b remain exposed.

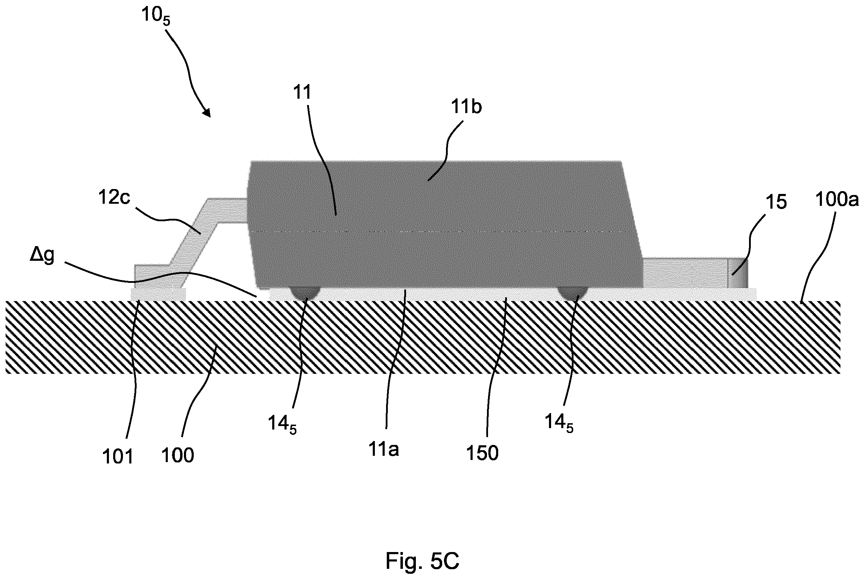

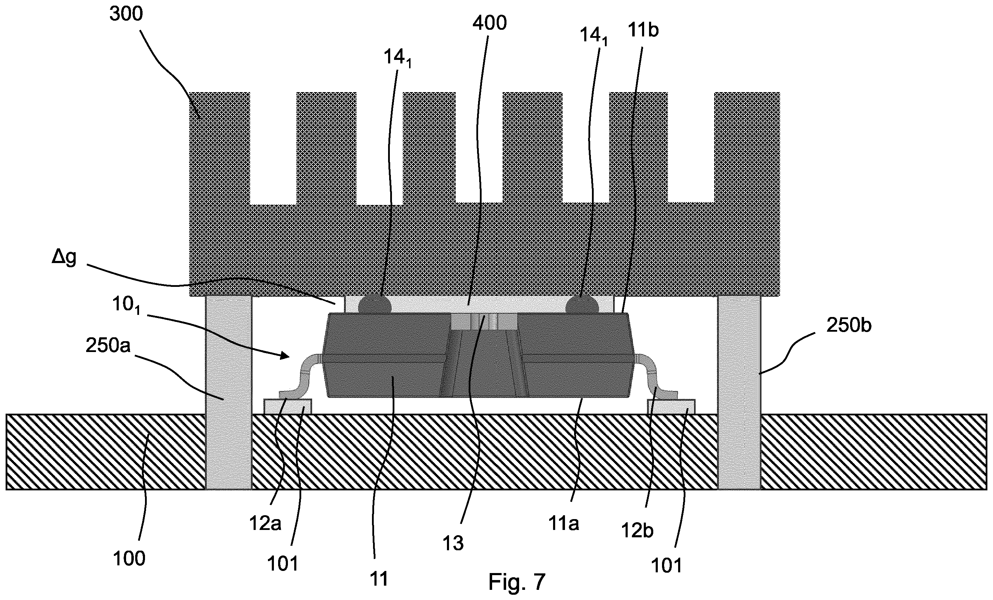

The semiconductor package 10₁ thus formed has a package surface side 11a oriented at the PCB side 100a and an opposite package surface side 11b oriented at the heat sink 300. In practise, such top-side cooled semiconductor package is mounted with its surface side 11a on a first, top side 100a of a printed circuit board 100, see Figures 5C and 7, with the exposed terminals 12a-12b electrically connected (soldered) with conductive pads 101 of the PCB 100, whereas the other surface side 11b of the semiconductor package 10 serves to accommodate a heat sink element 300, see Figure 7.

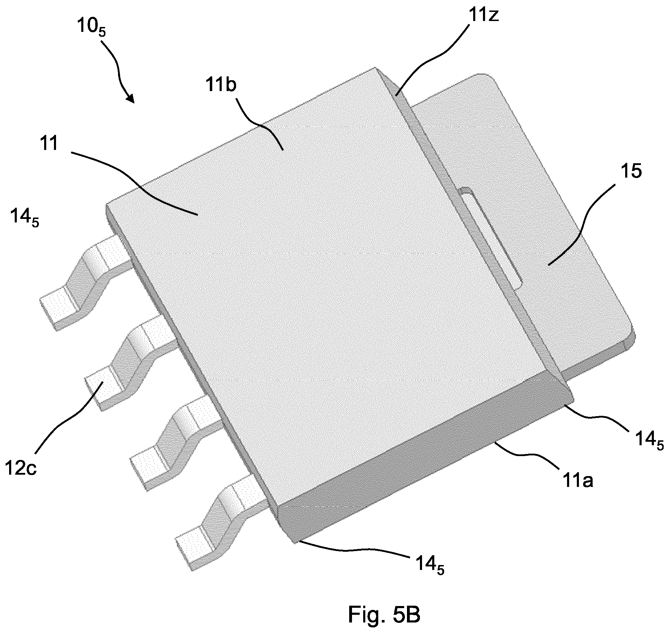

To ensure a proper electrical insulation between the exposed heat sink pad 13 of the semiconductor package 10₁ and the heatsink 300 (Figure 7), or a correct solder thickness of solder 150 between the side 11a and the PCB 100 (Figure 5B) is ensured, one or more resin spacer elements 14₁ are provided in the moulding resin 11 at either or both the package surface side 11a and the package surface side 11b.

In the example of Figures 1A-1D the one or more resin spacer elements 14₁ are provided in the moulding resin 11 at the package surface side 11b near the heat sink pad 13. As depicted the various resin spacer elements 14₁ extend from the plane formed by the respective package surface side 11b.

The various resin spacer elements 14₁ create a spacing between the package surface side 11b and any heat sink 300 mounted on top of the heat sink pad 13, as depicted in more detail in Figure 7. The height dimension of the spacing, sic. the height of at least one resin spacer element 14₁ is denoted in Figure 7 as Δg (delta gap) and ensures a constant spacing and accordingly a constant thickness of the TIM layer 400 between the heat sink pad 13 and the heat sink element 300. This guarantees a proper electrical insulation between the exposed heat sink pad 13 of the top-cooled semiconductor power package and the heatsink 300.

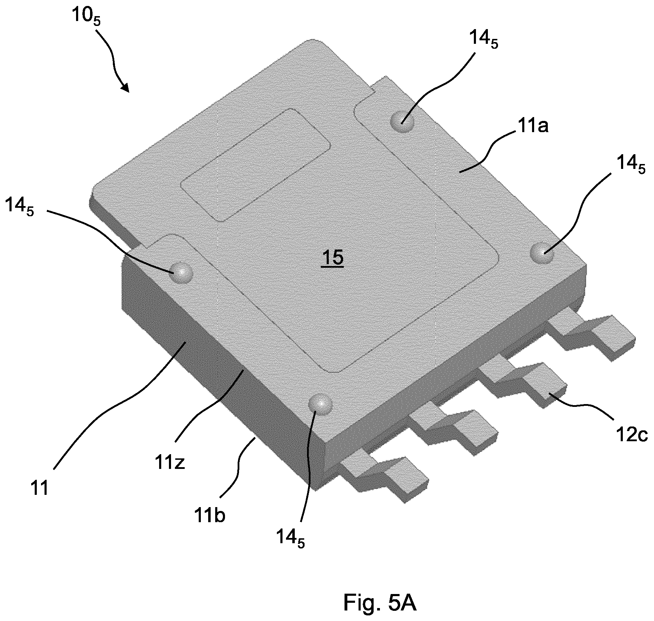

In Figures 1A-1D, the various resin spacer elements 14₁ are formed as a protruded feature and provided near or at a corner of the package surface side 11b near or around the exposed heat sink pad 13. In an alternative fifth example of Figures 5A-5C, the semiconductor package is depicted in a different orientation (being bottom cooled) capable of controlling the conductive adhesive/solder thickness, and not implementing TIM. The semiconductor power package 10₅ is provided with multiple resin spacer elements 14₅ near or at a corner at the I package surface side 11a. These resin spacer elements 14₅ are similarly formed as a protruded feature. In this fifth example, the constant height dimension of the spacing Δg (delta gap), sic. the height of protruded features 14₅ ensures a constant and correct solder thickness or similar conductive paste, of solder 150 and accordingly a proper electrical connection between the lead frame pad 15 with the top, first surface side 100a of the PCB 100.

In various examples (Figures 1A-1B-1C-1D, 5A-5B-5C), the resin spacer elements 14₁-14₅ are provided near or at an outer circumference 11z of the respective package surface side 11a (Figures 5A-5B-5C) or 11b (Figures 1A-1B-1C-1D). In other examples the resin spacer elements may be configured as one ridge 14₂-14₃-14₄-14₆.

In all examples, the electrical insulation between the exposed heat sink pad 13 and the heatsink 300, and/or the electrical connection between the lead frame 15 and the PCB 100 is not hampered whilst the proper spacing between the semiconductor package 10₁-10₂-10₃-10₄-10₅-10₆ and either the heatsink 300 and/or the PCB 100 is ensured.

In an example implementing ridges, the ridge may extend along an outer circumference 11z of the respective package surface side 11a-11b. In a particular example, it may be formed as a single circumferential ridge 14₆ circumventing the outer circumference 11z of the respective package surface side 11a-11b and surrounding the respective heat sink pad 13 or lead frame pad 15. The electrical insulation between the exposed heat sink pad 13 and the heatsink 300, and/or the electrical connection between the lead frame pad 15 and the PCB 100 is not hampered whilst ensuring the proper spacing Δg between the semiconductor package and either the heatsink 300 and/or the PCB 100.

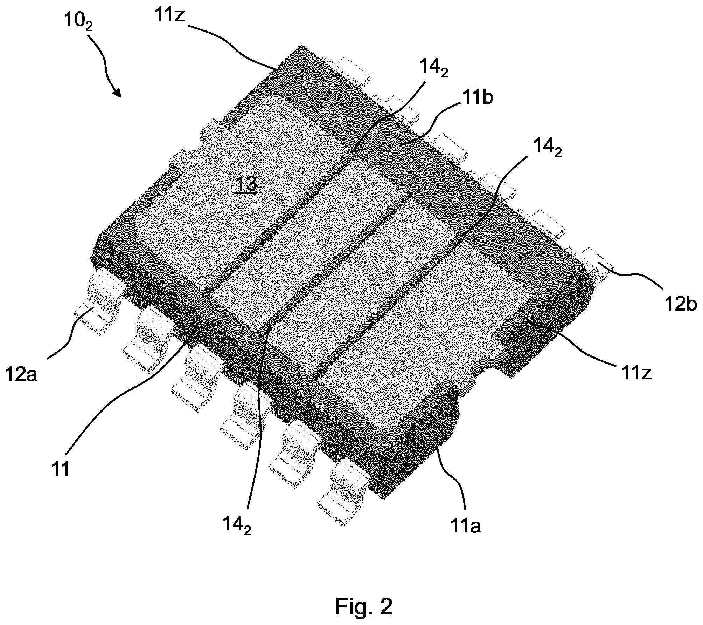

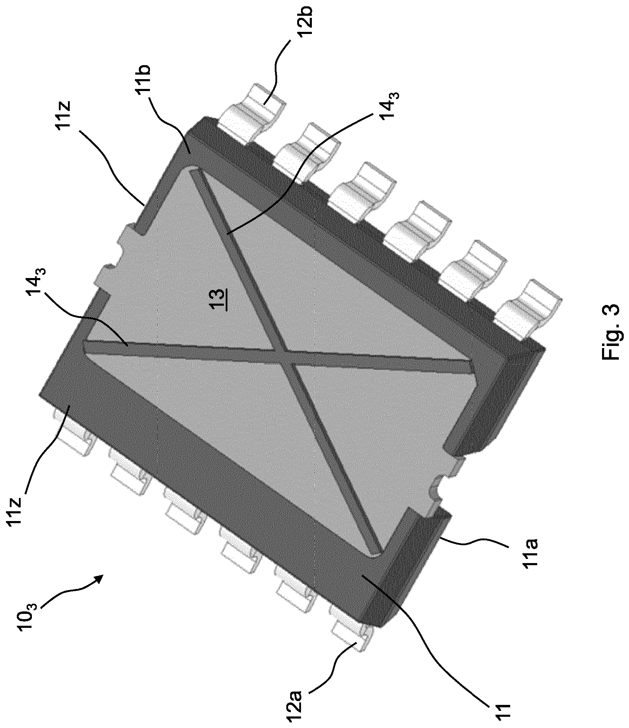

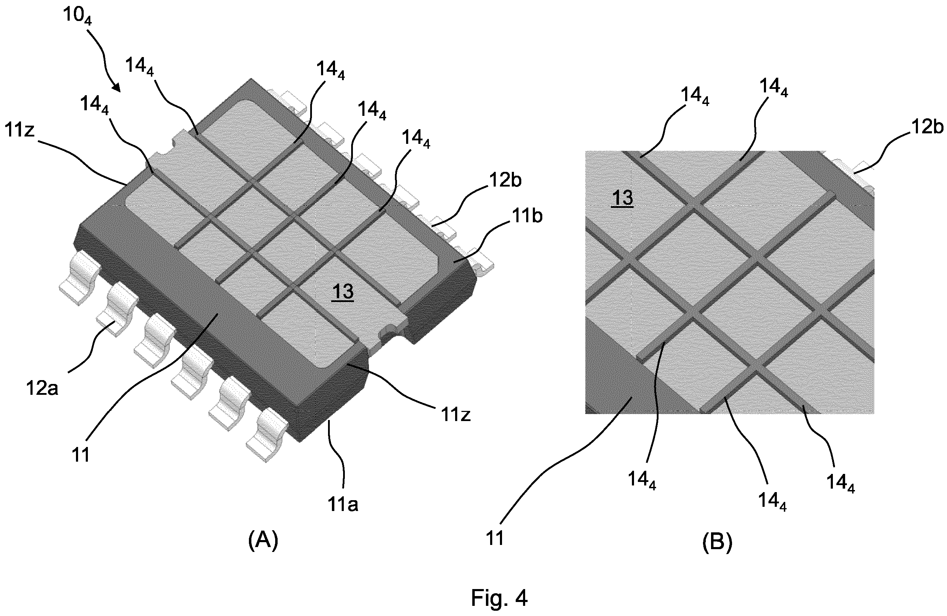

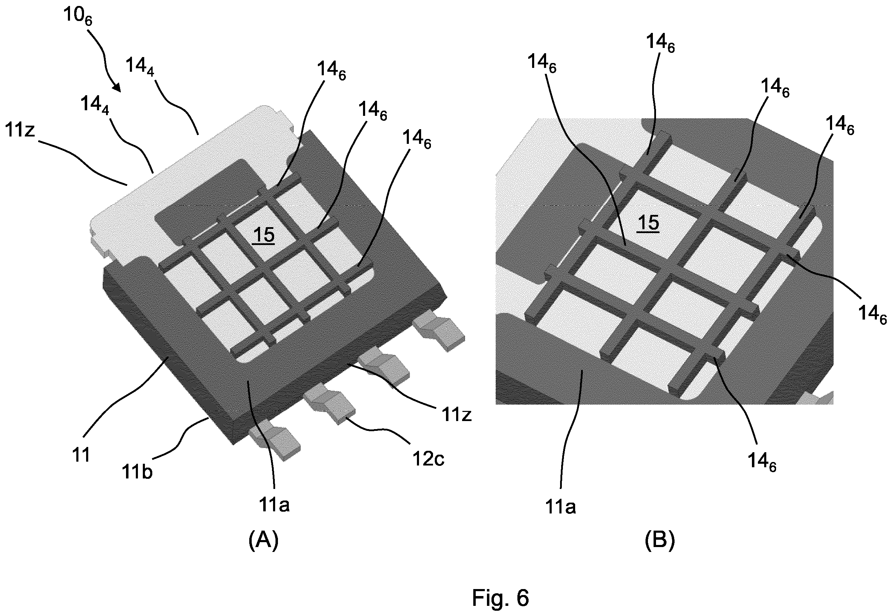

Various examples of semiconductor packages 10₂-10₃-10₄-10₆ as shown in Figures 2, 3, 4A-4B, 6A-6B, depict resin spacer elements 14₂-14₃-14₄-14₆ formed as ridges, which extends across the package surface side 11b containing the exposed heat sink pad 13, either in a straight, parallel manner (second example of Figure 2), or in an obliquely, diagonal manner (third example of Figure 3), or the ridges are formed as a (rectangular) grid on the package surface side 11b (fourth example of Figures 4A-4B) or as a (rectangular) grid on the lead frame package surface side 11a (sixth example of Figures 6A-6B).

It should be noted, that in all examples of the disclosure, the various examples of resin spacer elements 14₁-14₂-14₃-14₄-14₅-14₆ either shaped as a protruded feature, dimple, or ridge, may have a height of 20-50 µm, in particular 20-30 µm, and a width of 20-50 µm. The protruded features may have a spherical or rectangular shapes. All examples ensure a constant spacing and a constant thickness of the TIM layer 400 between the drain pad 13 and the heat sink element 300, guaranteeing a proper electrical insulation between the exposed heat sink pad 13 of the top-cooled semiconductor power package and the heatsink 300 and/or a constant and correct solder thickness of solder 200 and thus a proper electrical connection between the lead frame pad 15 with the top, first surface side 100a of the PCB 100.

When implementing resin spacer elements 14₁ as protruded features, at least three protruded features would be required on the lead frame package surface side 11a and/or the drain pad package surface side 11b either to ensure a proper and constant spacing Δg (and thickness of either the solder layer 150 or the TIM layer 400). A preferred examples implements four protruded features 14₁ and 14₅ at each of the four corners of the drain pad package surface side 11b (Figures 1A-1C) or of the lead frame package surface side 11a (Figures 5A-5B).

Similarly, the number of resin spacer elements / ridges 14₂-14₃-14₄-14₆ in Figures 2, 3, 4A-4B, 6A-6B should be at least two and positioned as some distance from each other in other.

The above configurations of protruded features and ridges ensure a stable positioning of the semiconductor package on the first, top surface side 101a of the PCB 100 and/or the heat sink element 300 on the drain pad surface side 11b.

The resin spacer elements / protruded features / ridges 14₁-14₂-14₃-14₄-14₅-14₆ reduce or limit any load on the top, drain pad package surface side 11b of the semiconductor packages 10₁-10₂-10₃-10₄-10₅-10₆ coming from the mounted heatsink element 300, thus preventing additional mechanical stress on the semiconductor package. In the prior art, such heat sink elements 300 are clamped on the semiconductor package and the PCB using mounting screws 250a-250b (see Figure 7) and if the stress is too high, it may cause the degradation of internal features of package (such as a die crack, or internal solder crack). This phenomenon is thus prevented with the resin spacer elements / protruded features / ridges 14₁-14₂-14₃-14₄-14₅-14₆ of the present disclosure.

The use of resin spacer elements / protruded features / ridges 14₁-14₂-14₃-14₄-14₅-14₆ will also guarantee enough clearance (spacing) between the top heatsink 300 and the top, drain pad package surface side 11b, while enabling a better control of the TIM layer thickness, which will guarantee a minimum electrical insulation strength between the heat sink 300 (at ground potential) and exposed drain pad 13 of the semiconductor package (which is at high voltage, HV).

The various configurations of the resin spacer elements / protruded features / ridges 14₁-14₂-14₃-14₄-14₅-14₆ can be provided effectively during the encapsulation process of the semiconductor package, by adding corresponding, mirrored indentations in the mould cavities used for encapsulating.

As a final remark, it will be understood that the various configurations of the resin spacer elements / protruded features / ridges 14₁-14₂-14₃-14₄-14₅-14₆ can be implemented on either the bottom, lead frame package surface side 11a and/or the top, drain pad package surface side 11b of the semiconductor package, or on both.

The above disclosed configurations can be implemented for a variety of high power and heat generating electronics components, such as MOSFETs, diodes, a bipolar transistors, IGBTs, etc

### LIST OF REFERENCE NUMERALS USED

- 10ₙ: semiconductor package (1^{st}-2^{nd}-3^{rd}-4^{th}-5^{th} example)
- 11: moulding resin encapsulant
- 11a: first package surface side
- 11b: second package surface side
- 12: lead frame
- 12a-12b-12c: terminals
- 12z: bond clip
- 13: heat sink pad (first example)
- 14ₙ: spacer element (1^{st}-2^{nd}-3^{rd}-4^{th} -5^{th} example)
- 15: lead frame pad or heat sink pad (fifth example)
- 16: semiconductor die
- 16a: first die surface
- 16b: second die surface
- 100: printed circuit board (PCB)
- 100a: first semiconductor package surface side of printed circuit board
- 101: conductive pads of PCB
- 150: solder
- 300: heat sink element
- 250a-250b: mounting screws for heat sink element
- 400: thermal interface material (TIM)

## Claims

1. A semiconductor package at least comprising:
a lead frame made from an electrically conductive metal material as well as at least two terminals;
at least one semiconductor die structure having a first die side and a second die side opposite to the first die side and mounted with its second die side on the lead frame;
a plurality of connections electrically and mechanically connecting the at least one semiconductor die structure with the at least two terminals of the lead frame;
at least one heat sink pad mounted to the first die side of the semiconductor die structure; and
a moulding resin encapsulating the lead frame, the at least one semiconductor die structure, the plurality of connections, the at least one heat sink pad and the at least two terminals leaving at least a portion of the heat sink pad and at least a portion of the at least two terminals exposed, and forming the semiconductor package having a heat sink pad package surface side and a lead frame package surface side, wherein the moulding resin at the heat sink pad package surface side and/or the lead frame package surface side is provided with at least one resin spacer element extending from the respective package surface side.

2. The semiconductor package according to claim 1, wherein the at least one resin spacer element is provided near or at an outer circumference of the respective package surface side.

3. The semiconductor package according to claim 1 or 2, wherein the at least one resin spacer element is provided near or at a corner of the respective package surface side.

4. The semiconductor package according to any one or more of the preceding claims, wherein the at least one resin spacer element is configured as a protruded feature.

5. The semiconductor package according to any one or more of the preceding claims, wherein the at least one resin spacer element is configured as at least one ridge.

6. The semiconductor package according to claim 5, wherein the at least one ridge extends along an outer circumference of the respective package surface side.

7. The semiconductor package according to claim 6, wherein the at least one ridge is formed as a single circumferential ridge circumventing the outer circumference of the respective package surface side.

8. The semiconductor package according to claim 5 or 6, wherein the at least one ridge extends across the respective package surface side.

9. The semiconductor package according to any one or more of the claims 5 to 8, wherein the at least one ridge is formed as a grid.

10. The semiconductor package according to any one or more of the preceding claims, wherein the at least one resin spacer element has a height of 20-50 µm, in particular 20-30 µm.

11. The semiconductor package according to any one or more of the preceding claims, wherein the at least one resin spacer element has a width of 20-50 µm.
